# EUROPEAN PATENT APPLICATION

(11) **EP 3 715 498 A1**
(43) Date of publication of application: **30.09.2020**
(21) Application number: 17905005.9
(22) Date of filing: 22.12.2017
(51) Int. Cl.: C23C 14/34

(54) **PLATE COATING DEVICE**

(30) Priority: 21.11.2017 CN 201721563337 U
(71) Applicant: Beijing Apollo Ding Rong Solar Technology Co., Ltd, Beijing 100176 (CN)
(72) Inventor: SHI, Shuanlin, Beijing 100176 (CN)
(74) Representative: Cohausz & Florack
(86) International application number: PCT/CN2017/117925
(87) International publication number: WO 2019/100506

(57) **Abstract**

Provided is a plate coating equipment, including a first target material coating chamber (1) and a second target material coating chamber (2), where an separation chamber (3) is arranged between the first target material coating chamber (1) and the second target material coating chamber (2), and a molecular pump (4) is arranged in the separation chamber (3), where the separation chamber (3) is separated from the first target material coating chamber (1) through a first separator (5) and is separated from the second target material coating chamber (2) through a second separator (6), each of the first separator (5) and the second separator (6) has a slit (7), and the first separator (5) is provided with a purging device (8). The present utility model can effectively separate various chambers in a coating equipment, ensure a glass coating quality, and have advantages of simple structure and low manufacturing cost.

## Description

### TECHNICAL FIELD

The present utility model relates to a coating equipment, and more particularly to a plate coating equipment.

### BACKGROUND

In a plate coating equipment, according to different process technologies, different kinds of target materials are required to be sputtered and deposited for coating at the same time. However, each target material has its own process requirement, and an auxiliary sputtering gas, such as O₂, H₂, N₂, needs to be added at the same time in addition to a main sputtering gas, so sputtering processes of a variety of target materials occur in the same vacuum chamber. Thus, in order that reaction gases among the different target materials in the process technology do not affect each other, different target material sputtering processes need to be separated to ensure a coating quality.

### SUMMARY

The purpose of the utility model is to provide a plate coating equipment to solve the technical problems in the related art, which can effectively separate various chambers in the coating equipment, ensure a glass coating quality, and have advantages of simple structure and low manufacturing cost.

There is provided a plate coating equipment in the present utility model, including a first target material coating chamber and a second target material coating chamber, wherein an separation chamber is arranged between the first target material coating chamber and the second target material coating chamber, and a molecular pump is arranged in the separation chamber, where the separation chamber is separated from the first target material coating chamber through a first separator and is separated from the second target material coating chamber through a second separator, each of the first separator and the second separator has a slit, and the first separator is provided with a purging device.

In the above-mentioned plate coating equipment, the purging device is located on a side of the first separator close to the separation chamber.

In the above-mentioned plate coating equipment, the purging device includes a gas pipe, an end plate and a flow control valve, there are two end plates respectively fixed at two ends of the slit in a longitudinal direction, the gas pipe is fixed on the two end plates, an inlet end of the gas pipe is connected to an outlet end of the flow control valve, an inlet end of the flow control valve is connected to a gas source through a pipeline, and the gas pipe has a nozzle.

In the above-mentioned plate coating equipment, the gas pipe has an annular structure.

In the above-mentioned plate coating equipment, a jet direction of the nozzle is toward the slit, and an angle between the nozzle and the slit is 30°-60°.

In the above-mentioned plate coating equipment, the angle between the nozzle and the slit is 45°.

In the above-mentioned plate coating equipment, an inner wall surface of the slit is a rough surface.

In the above-mentioned plate coating equipment, the number of molecular pumps is four.

Compared with the prior art, the utility model is provided with a molecular pump in the separation chamber. The molecular pump can pump the gas from the separation chamber, so as to prevent the gas from entering other coating chambers through a slit. In order to ensure a coating quality in each target material coating chamber, a purging device also is provided on a first separator in addition to providing a molecular pump inside the target material coating chamber. The gas entering into the slit can be blown back to the first target material coating chamber through the purging of the purging device, and then be pumped out by the molecular pump in the first target material coating chamber, so as to solve the problem of gas escape.

### BRIEF DESCRIPTION OF THE DRAWINGS

FIG. 1 is a top view of a plate coating equipment in the related art;
FIG.2 is a top view of an embodiment of the present utility model; and
FIG. 3 is an isometric view of a first separator and a purging device. Reference numerals:

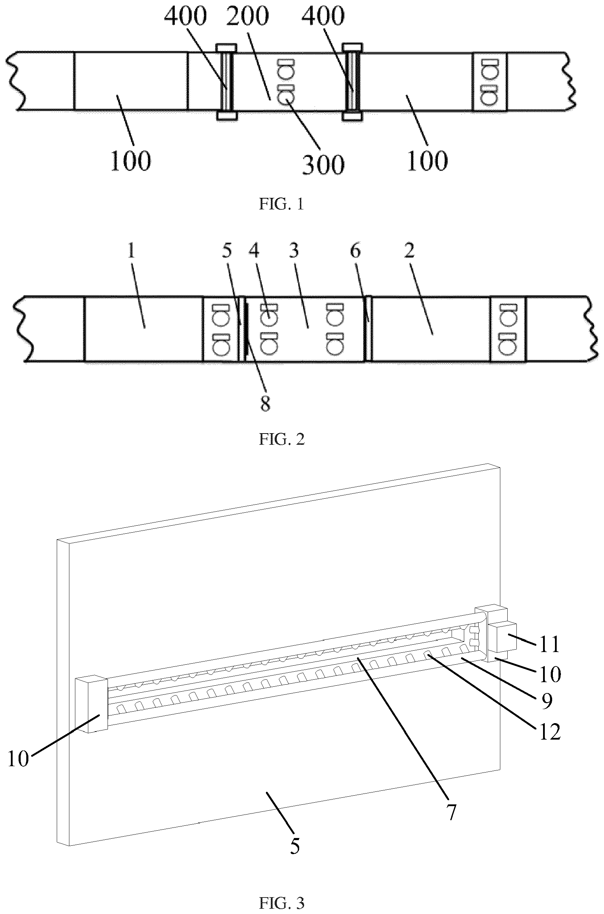

   In FIG. 1: 100-process chamber, 200-separation chamber, 300-molecular pump, 400-flap valve;
   In FIGS. 2 and 3: 1-first target material coating chamber, 2-second material target coating chamber, 3-separation chamber, 4-molecular pump, 5-first separator, 6-second separator, 7-slit, 8-purging device, 9- gas pipe, 10-end plate, 11-flow control valve, 12-nozzle.

### DETAILED DESCRIPTION

Embodiments of the present utility model are described in detail below, examples of which are illustrated in the accompanying drawings, in which the same or similar reference numerals denote the same or similar elements or elements having the same or similar functions throughout. The embodiments described below with reference to the drawings are exemplary, which are merely explanations, rather than limitations to the present utility model. In embodiments of the present utility model, as shown in FIG. 2 and FIG. 3, a plate coating equipment includes a first target material coating chamber 1 and a second target material coating chamber 2. Target materials in the first target material coating chamber 1 and the second target material coating chamber 2 are different, and accordingly a main sputtering gas and an auxiliary sputtering gas there through are also different. In order to prevent the atmosphere escape from affecting the coating process, a separation chamber 3 is arranged between the first target material coating chamber 1 the second target material coating chamber 2, and a molecular pump 4 is provided in the separation chamber 3, preferably, there are four molecular pumps 4. The molecular pump 4 is used for pumping the gas from the separation chamber 3. The separation chamber 3 is separated from the first target material coating chamber 1 through a first separator 5. The separation chamber 3 is separated from the second target material coating chamber 2 through a second separator 6. Each of the first separator 5 and the second separator 6 has a slit 7 for passing a plate. In order to increase the separation effect, a purging device 8 is further provided. The gas in the slit 7 can be blown back into the original coating chamber by the purging device 8.

In some embodiments, the purging device 8 is disposed on the first separator 5, and the purging device 8 is located in the separation chamber 3. A purging direction of the purging device 8 is toward the side of the first target material coating chamber 1. Such a structure has advantages of low manufacturing cost and good separation effect.

In the above embodiment, the purging device 8 can adopt any device with a blowing function. In order to ensure a separation effect, there is provided a preferred solution in this embodiment. As shown in FIG. 3, the purging device 8 includes a gas pipe 9, an end plate 10 and a flow control valve 11. There are two end plates 10 respectively fixed at two ends of the slit 7by screws in a longitudinal direction. The gas pipe 9 is fixed on the two end plates 10. An inlet end of the gas pipe 9 is connected to an outlet end of the flow control valve 11. An inlet end of the flow control valve 11 is connected to a gas source through a pipe. The gas pipe 9 has a nozzle 12.

During operation, a gas supply amount of the gas pipe 9 is controlled by the flow control valve 11. The gas in the gas source is the same as the main sputtering gas in the first target material coating chamber 1. To ensure the effect, the gas pipe 9 is preferably an annular structure that is contoured with the slit 7and mounted around the slit 7. A jet direction of the nozzle 12 is toward the slit 7. An angle between the nozzle 12 and the slit 7 is 30°-60°, preferably 45°.

In addition, an inner wall surface of the slit 7 made of a rough surface by sandblasting can also play a role in alleviating the atmosphere escape to a certain degree.

The structure, features, and effects of the utility model are described in detail with reference to the embodiments shown in the drawings. The above description is only some embodiments of the utility model. However, the implementation scope thereof is not limited by the drawings. Any changes made in accordance with the concept of this utility model or equivalent embodiments that are modified to be equivalent changes, without exceeding the spirit covered by the description and illustration, are still within the protection scope of the utility model.

## Claims

1. A plate coating equipment, comprising a first target material coating chamber (1) and a second target material coating chamber (2), wherein an separation chamber (3) is arranged between the first target material coating chamber (1) and the second target material coating chamber (2), and a molecular pump (4) is arranged in the separation chamber (3), wherein the separation chamber (3) is separated from the first target material coating chamber (1) through a first separator (5) and is separated from the second target material coating chamber (2)through a second separator (6), each of the first separator (5) and the second separator (6) has a slit (7), and the first separator (5) is provided with a purging device (8).

2. The plate coating equipment according to claim 1, wherein the purging device (8) is located on a side of the first separator (5) close to the separation chamber (3).

3. The plate coating equipment according to claim 1 or claim 2, wherein the purging device (8) comprises a gas pipe (9), an end plate (10) and a flow control valve (11), there are two end plates (10) respectively fixed at two ends of the slit (7) in a longitudinal direction, the gas pipe (9) is fixed on the two end plates (10), an inlet end of the gas pipe (9) is connected to an outlet end of the flow control valve (11), an inlet end of the flow control valve (11) is connected to a gas source through a pipeline, and the gas pipe (9) has a nozzle (12).

4. The plate coating equipment according to claim 3, wherein the gas pipe (9) has an annular structure.

5. The plate coating equipment according to claim 3, wherein a jet direction of the nozzle (12) is toward the slit (7), and an angle between the nozzle (12) and the slit (7) is 30°-60°.

6. The plate coating equipment according to claim 5, wherein the angle between the nozzle (12) and the slit (7) is 45°.

7. The plate coating equipment according to claim 1, wherein an inner wall surface of the slit (7) is a rough surface.

8. The plate coating equipment according to claim 1, wherein a number of molecular pumps (4) is four.
